# EUROPEAN PATENT SPECIFICATION

(11) **EP 4 425 717 B1**
(45) Date of publication and mention of the grant of the patent: **03.09.2025**
(21) Application number: 24164750.2
(22) Date of filing: 11.11.2020
(51) Int. Cl.: H05K 1/18, H01R 12/71, H05K 1/14

(54) **CIRCUIT BOARD ASSEMBLY AND ELECTRONIC DEVICE**
LEITERPLATTENANORDNUNG UND ELEKTRONISCHE VORRICHTUNG
ENSEMBLE CARTE DE CIRCUIT IMPRIMÉ ET DISPOSITIF ÉLECTRONIQUE

(30) Priority: 05.12.2019 CN 201911232961
(43) Date of publication of application: 04.09.2024
(62) Divisional of application: 20897277.8
(73) Proprietor: Honor Device Co., Ltd., Shenzhen, Guangdong 518040 (CN)
(72) Inventor: LUO, Fan, Shenzhen, 518040 (CN)
(74) Representative: Epping - Hermann - Fischer

(56) References cited:
- EP-A2- 1 315 243
- WO-A1-2006/057424
- CN-A- 105 828 530
- DE-A1- 102015 221 146
- JP-A- 2005 251 889

## Description

### TECHNICAL FIELD

This application relates to the field of electronic component technologies, and in particular, to a circuit board assembly and an electronic device.

### BACKGROUND

A printed circuit board (Printed Circuit Board, PCB) is an important part in an electronic product, and printed circuit boards may be connected by using a board-to-board connector (Board-to-board connectors, BTB).

Many electronic elements are disposed on the periphery of the board-to-board connector for functions such as filtering. After the board-to-board connector is connected to the printed circuit board, these electronic elements are disposed on a surface of the printed circuit board and surround the board-to-board connector. During actual production, assembly, and repair at a service center, the electronic elements are easily damaged due to impact, and consequently poor functions are caused.

CN 105 828 530 A provides a circuit board and an electronic device and relates to the technical field of electronic device manufacture. The circuit board comprises a circuit board body; a board-to-board connector arranged on the circuit board body; a patch device arranged on the circuit board body; and an anti-collision structure arranged on the circuit board body and used for isolating the patch device from the board-to-board connector, wherein the surface mounted patch device is accommodated in a cavity provided in the anti-collision structure.

JP 2005 251889 A relates to a shield (electromagnetic shielding) structure of a three-dimensional electronic circuit device in which a circuit board on which electronic components are mounted is relayed using a relay board or the like to form a three-dimensional structure, wherein electronic components are accommodated in hollow portions provided in the relay board.

DE 10 2015 221146 A1 relates to an electronic component comprising at least one multilayer circuit carrier which is equipped with a number of mechanical and/or electronic components. The circuit carrier is formed from a number of circuit carrier layers, at least one of the mechanical components being embedded in the circuit carrier and being accessible or exposable from the outside.

WO 2006/057424 A1 relates to a first printed board on which a ground pattern is provided and an electronic part is mounted and a second printed board on which a ground pattern is provided and an electronic part is mounted which are oppositely arranged, and circuits of the first printed board and the second printed board are connected by a connector with a frame-like shield. In the connector with a shield, a frame body is formed of an insulator such as a resin, a connection terminal is provided inside the frame body, and a conductor is provided on the entire outer periphery of the frame body. In the conductor, the shield is formed by both the ground pattern of the first printed board and the ground pattern of the second printed board. The frame body shields the electronic parts.

EP 1 315 243 A2 relates to an electronic component assembly mounted on a circuit board that comprises an intermediate connector mounted on the circuit board and having a first space for accommodating first electronic components provided on the circuit board and a unit body provided on the intermediate connector and connected to the circuit board through the intermediate connector. The unit body comprises a connector member having a second space and a mounting member having second electronic component accommodated in the second space.

### SUMMARY

The invention is set out in the appended claims.

An objective of this application is to provide a circuit board assembly and an electronic device, so that peripheral electronic elements are not damaged by impact during production, assembly or repair of the board-to-board connector.

According to a first aspect, a circuit board assembly is provided, including:
a circuit board;
a backing plate fixedly connected to one side of the circuit board, where the backing plate is provided with an accommodation portion;
an electronic element accommodated in the accommodation portion and connected to the circuit board; and
a board-to-board connector fixedly connected to one side that is of the backing plate and that is away from the circuit board.

The accommodation portion is provided on the backing plate, and the electronic element is accommodated in the accommodation portion, so that the electronic element is located in the space under the board-to-board connector. Therefore, not only damage caused by impact of the electronic element can be prevented, but also space of the circuit board assembly can be greatly saved.

The accommodation portion is a blind via provided on the backing plate, and the blind via is recessed from one side that is of the backing plate and that is close to the circuit board to one side close to the board-to-board connector.

The accommodation portion is arranged as the blind via, so that the electronic element can be shielded to a certain extent, which is applicable to an electronic element with a shielding requirement.

An inner wall of the accommodation portion is provided with a shield layer. The shield layer is provided so that the electronic element can be further shielded.

The shield layer may be formed by plating gold and nickel on a copper layer.

In a possible implementation, a first soldering pad is further included, where the electronic element is fastened and electrically connected to the circuit board by using the first soldering pad. The first soldering pad may be a soldering pad of an electronic shielding component, so that the electronic element does not interfere with work of another component.

In a possible implementation, a second soldering pad is further included, where the board-to-board connector is fixedly connected to the backing plate by using the second soldering pad. The second soldering pad is disposed so that the board-to-board connector can be further elevated, thereby further providing larger accommodation space for the electronic element.

In a possible implementation, the backing plate is provided with a first via, an inner wall of the first via is provided with a first conductive layer, the first conductive layer is electrically connected to the board-to-board connector by using the second soldering pad, and the first conductive layer is electrically connected to the circuit board. The first conductive layer is provided to facilitate electrical connection between the board-to-board connector and the circuit board.

Copper may be plated in the first via to form the first conductive layer.

In a possible implementation, the circuit board is provided with a second via, and an inner wall of the second via is provided with a second conductive layer; and
the second conductive layer is electrically connected to the electronic element.

The second via and the second conductive layer are provided so that the electronic element can be led out to be connected to another related component, so as to meet a design requirement of a circuit.

Copper may be plated in the second via to form the second conductive layer.

In a possible implementation, the circuit board is provided with a third via, and the third via communicates with the first via;
an inner wall of the third via is provided with a third conductive layer, and the third conductive layer is electrically connected to the first conductive layer; and
the circuit board is further provided with a fourth conductive layer, and the fourth conductive layer is electrically connected to the third conductive layer and the second conductive layer separately.

Copper may be plated in the third via to form the third conductive layer. The fourth conductive layer may be buried in the circuit board, to electrically connect the third conductive layer to the second conductive layer.

According to an example, which is not covered by the claims, a circuit board assembly is provided, including:
a circuit board;
a board-to-board connector, where the board-to-board connector is connected to the circuit board, and the board-to-board connector includes:
   a body, where an accommodation portion is provided inside the body; and
   a conductive portion embedded in the body; and
   an electronic element, where the electronic element is connected to the circuit board, and the electronic element is accommodated in the accommodation portion.

In the circuit board assembly and the electronic device provided in this application, the electronic element is accommodated in the accommodation portion, and the accommodation portion is provided in the body of the board-to-board connector, so that the electronic element is located in the space under the board-to-board connector. Therefore, not only damage caused by impact of the electronic element can be prevented, but also space of the circuit board assembly can be greatly saved.

According to a second aspect, an electronic device is provided, including more than two circuit board assemblies, where each of the more than two circuit board assemblies includes a board-to-board connector, the more than two circuit board assemblies are connected by using respective board-to-board connectors, and at least one circuit board assembly is the circuit board assembly as defined in claim 1.

At least one circuit board assembly is arranged as the circuit board assembly provided in this application, so that the at least one circuit board assembly saves space occupied by an electronic element, thereby facilitating miniaturization and thinning of a mobile phone.

The technical solutions provided in this application may achieve the following beneficial effects: In the circuit board assembly and the electronic device provided in this application, the electronic element is accommodated in the accommodation portion, and the accommodation portion may be provided on the backing plate, or may be provided in the body of the board-to-board connector, so that the electronic element is located in the space under the board-to-board connector. Therefore, not only damage caused by impact of the electronic element can be prevented, but also space of the circuit board assembly can be greatly saved, thereby facilitating miniaturization and thinning of the electronic device.

### BRIEF DESCRIPTION OF DRAWINGS

FIG. 1 is a schematic exploded diagram of a structure of a circuit board assembly;
FIG. 2 is a sectional drawing of a structure of a circuit board assembly according to an embodiment which is not covered by the claims;
FIG. 3 is a sectional drawing of a structure of a circuit board assembly according to another embodiment which is not covered by the claims;
FIG. 4 is a sectional drawing of a structure of a circuit board assembly according to an embodiment of the invention;
FIG. 5 is a sectional drawing of a structure of a circuit board assembly according to yet another embodiment which is not covered by the claims; and
FIG. 6 is a sectional drawing of a structure of a circuit board assembly according to still yet another embodiment which is not covered by the claims.

### Reference numerals:

100: Circuit board assembly;
Circuit board;
11: Second via;
12: Second conductive layer;
13: Third via;
14: Third conductive layer;
15: Fourth conductive layer;
2: Backing plate;
21: Accommodation portion;
211: Shield layer;
22: First via;
23: First conductive layer;
3: Electronic element;
4: Board-to-board connector;
5: First soldering pad;
6: Second soldering pad;
200: Circuit board assembly;
10: Circuit board;
20: Board-to-board connector;
201: Body;
201a: Accommodation portion;
202: Conductive portion;
30: Electronic element.

### DESCRIPTION OF EMBODIMENTS

The terms used in the embodiments of this application are merely for the purpose of illustrating specific embodiments, and are not intended to limit this application. The terms "a", "said" and "the" of singular forms used in the embodiments and the appended claims of this application are also intended to include plural forms, unless otherwise specified in the context clearly.

It should be understood that the term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

It should be noted that, direction terms such as "top", "bottom", "left", and "right" described in the embodiments of this application are described from an angle shown in the accompanying drawings, and should not be construed as a limitation to the embodiments of this application. In addition, in the context, it should be further noted that, when it is mentioned that an element is connected to the "top" or "bottom" of another element, the element cannot only be directly connected to the "top" or "bottom" of the another element, but may also be indirectly connected to the "top" or "bottom" of the another element by using an intermediate element.

An embodiment of this application provides an electronic device. The electronic device may be a mobile phone, a tablet computer, or another electronic product. These electronic devices usually include mainboards. A mobile phone is used as an example, a mainboard may be connected to a circuit board of a component such as a camera, a battery, or a USB by using a board-to-board connector, and other circuit boards may also be connected by using board-to-board connectors. An electronic element such as a capacitor, an inductor, or a resistor is disposed on the periphery of the board-to-board connector. With deeper development of an integrated and miniaturized design of the mobile phone, layout space of the mainboard or other circuit boards becomes increasingly limited, and these electronic elements are easily damaged by impact during assembly or repair. A circuit board assembly and the electronic device provided in the embodiments of this application can resolve the technical problem that layout space of a circuit board is limited and electronic elements are damaged.

An embodiment of this application provides an electronic device, including more than two circuit board assemblies, where one circuit board assembly may include a mainboard of the electronic device, and other circuit board assemblies may include other circuit boards on the electronic device. Each of the more than two circuit board assemblies may include a board-to-board connector, and the more than two circuit board assemblies are connected by using respective board-to-board connectors. At least one circuit board assembly is the circuit board assembly provided in any embodiment of this application.

In other words, in the electronic device provided in this embodiment of this application, at least one circuit board assembly has a compact layout structure, so that space occupied by electronic elements can be reduced, thereby implementing miniaturization and thinning of the electronic device, and preventing the electronic elements from being damaged by impact during assembly and repair.

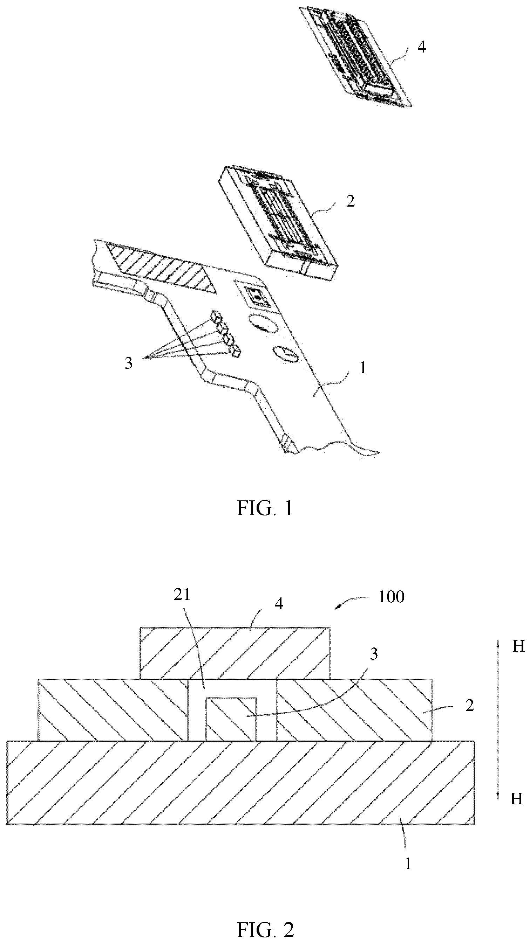

FIG. 1 is a schematic exploded diagram of a structure of a circuit board assembly. This embodiment of this application provides a circuit board assembly 100, including a circuit board 1, a backing plate 2, one or more electronic elements 3, and a board-to-board connector 4. The electronic elements 3 in this embodiment of this application may include one or more electronic elements.

FIG. 2 is a sectional drawing of a structure of a circuit board assembly according to an embodiment which is not covered by the claims. Referring to the circuit board assembly 100 in FIG. 1 and FIG. 2, the backing plate 2 is fixedly connected to one side of the circuit board 1. In a possible implementation, the backing plate 2 may be fastened to one side of the circuit board 1 through welding, and the backing plate 2 is provided with an accommodation portion 21.

The electronic element 3 is accommodated in the accommodation portion 21 and connected to the circuit board 1. In a possible implementation, the electronic element 3 may be welded to the circuit board 1, so that not only the electronic element 3 can be fastened, but also the electronic element 3 can be electrically connected to the circuit board 1.

The board-to-board connector 4 is fixedly connected to one side that is of the backing plate 2 and that is away from the circuit board 1. In a possible implementation, the board-to-board connector 4 may be fastened to the backing plate 2 through welding.

The electronic element 3 may be a filtering element, such as an electronic element having a function of a capacitive component, a resistive component, a common-mode inductor, or a protection diode (such as a TVS), used for the board-to-board connector 4. In a height direction H in FIG. 2, the electronic element 3 is accommodated in the interior space (namely, the accommodation portion 21) of the backing plate 2 under the board-to-board connector 4. Therefore, not only damage caused by impact of the electronic element 3 can be prevented, but also space of the circuit board assembly 100 can be greatly saved.

As shown in FIG. 2, in a specific implementation, the accommodation portion 21 may be a through via provided on the backing plate 2, the through via passes through the backing plate 2 along the height direction H of the circuit board assembly 100, and the board-to-board connector 4 covers the through via.

In this embodiment, the through via is made on the backing plate 2, the electronic element 3 is disposed in the through via, and the electronic element 3 may be welded to the circuit board 1, so that the electronic element 3 can be fixedly connected to the circuit board 1, and can also be electrically connected to the circuit board 1. The process of making the through via on the backing plate 2 is simple and can be implemented conveniently. The electronic element 3 may include an electronic element having a function of a capacitive component, a resistive component, a common-mode inductor, or a protection diode (such as a TVS). According to an actual design requirement, some of these electronic elements may be disposed in the accommodation portion 21, or all of these electronic elements may be disposed in the accommodation portion 21. This is not limited herein.

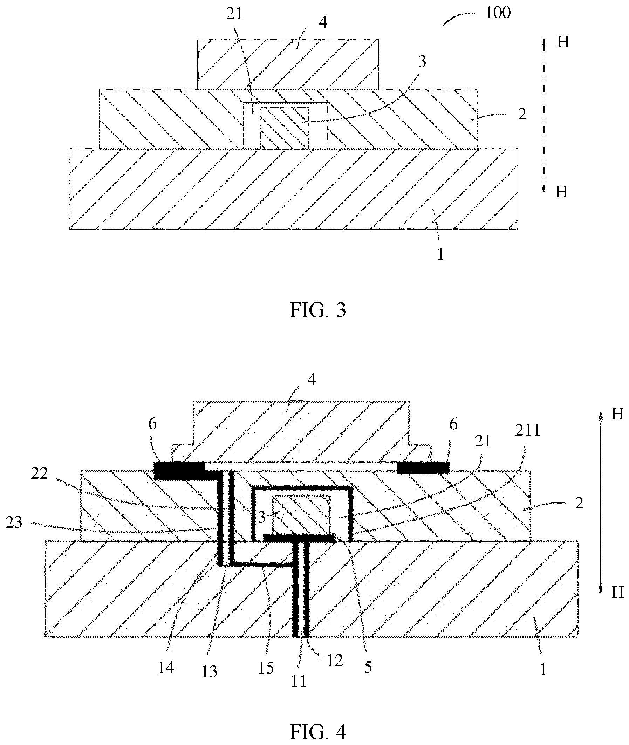

FIG. 3 is a sectional drawing of a structure of a circuit board assembly according to another embodiment which is not covered by the claims. As shown in FIG. 3, in a specific implementation, an accommodation portion 21 may be a blind via provided on the backing plate 2, and the blind via is recessed from one side that is of the backing plate 2 and that is close to the circuit board 1 to one side close to the board-to-board connector 4.

In other words, in a height direction of the circuit board assembly 100, the accommodation portion 21 does not pass through the backing plate 2. This structure can shield the electronic element to a certain extent, and is applicable to an electronic element with a shielding requirement.

FIG. 4 is a sectional drawing of a structure of a circuit board assembly according to an embodiment of the invention. As shown in FIG. 4, according to the invention, an inner wall of the accommodation portion 21 is provided with a shield layer 211. The shield layer 211 is provided to further shield the electronic element 3, thereby improving a filtering effect of a filtering component. The shield layer 211 may be formed by plating gold and nickel on a copper layer.

Still referring to FIG. 4, in a specific implementation, a first soldering pad 5 is disposed between the circuit board 1 and the electronic element 3, and the electronic element 3 is fastened and electrically connected to the circuit board 1 by using the first soldering pad 5. The first soldering pad 5 may be a soldering pad of an electronic shielding component. The first soldering pad 5 is disposed so that the electronic element 3 can be fastened and electrically connected to the circuit board 1. In addition, the first soldering pad 5 can further enable the electronic element 3 not to interfere with work of another component.

Still referring to FIG. 4, in a specific implementation, a second soldering pad 6 may be further disposed between the backing plate 2 and the board-to-board connector 4, and the board-to-board connector 4 is fixedly connected to the backing plate 2 by using the second soldering pad 6. The second soldering pad 6 is disposed so that the board-to-board connector 4 can be further elevated, thereby further providing larger accommodation space for the electronic element 3.

In a specific implementation, the backing plate 2 is provided with a first via 22, an inner wall of the first via 22 is provided with a first conductive layer 23, the first conductive layer 23 is electrically connected to the board-to-board connector 4 by using the second soldering pad 6, and the first conductive layer 23 is electrically connected to the circuit board 1. The first conductive layer 23 is provided to facilitate electrical connection between the board-to-board connector 4 and the circuit board 1. For example, copper may be plated in the first via 22 to form the first conductive layer 23.

Specifically, the first conductive layer 23 may be electrically connected to the second soldering pad 6, so that the first conductive layer 23 can be electrically connected to the board-to-board connector 4. The first conductive layer 23 may also be connected to the circuit board 1 by using a soldering pad or in another manner. This is not limited herein.

In a specific implementation, the circuit board 1 is provided with a second via 11, an inner wall of the second via 11 is provided with a second conductive layer 12, and the second conductive layer 12 is electrically connected to the electronic element 3.

The second via 11 and the second conductive layer 12 are provided so that the electronic element 3 can be led out to be connected to another related component, so as to meet a design requirement of a circuit. Copper may be plated in the second via 11 to form the second conductive layer 12.

As mentioned above, the first conductive layer 23 is provided to facilitate electrical connection between the board-to-board connector 4 and the circuit board 1. The first conductive layer 23 may be connected to the board-to-board connector 4 by using the second soldering pad 6 and connected to the circuit board 1 and the electronic element 3 by using the second conductive layer 12.

In a specific implementation, the circuit board 1 is provided with a third via 13, the third via 13 communicates with the first via 22, an inner wall of the third via 13 is provided with a third conductive layer 14, and the third conductive layer 14 is electrically connected to the first conductive layer 23. The circuit board 1 is further provided with a fourth conductive layer 15, and the fourth conductive layer 15 is electrically connected to the third conductive layer 14 and the second conductive layer 12 separately.

Copper may be plated in the third via 13 to form the third conductive layer 14. The fourth conductive layer 15 may be buried in the circuit board 1, to electrically connect the third conductive layer 14 to the second conductive layer 12. In the embodiment shown in FIG. 4, the board-to-board connector 4 is connected to the first soldering pad 5 by using the second soldering pad 6, the first conductive layer 23, the third conductive layer 14, the fourth conductive layer 15, and the second conductive layer 12.

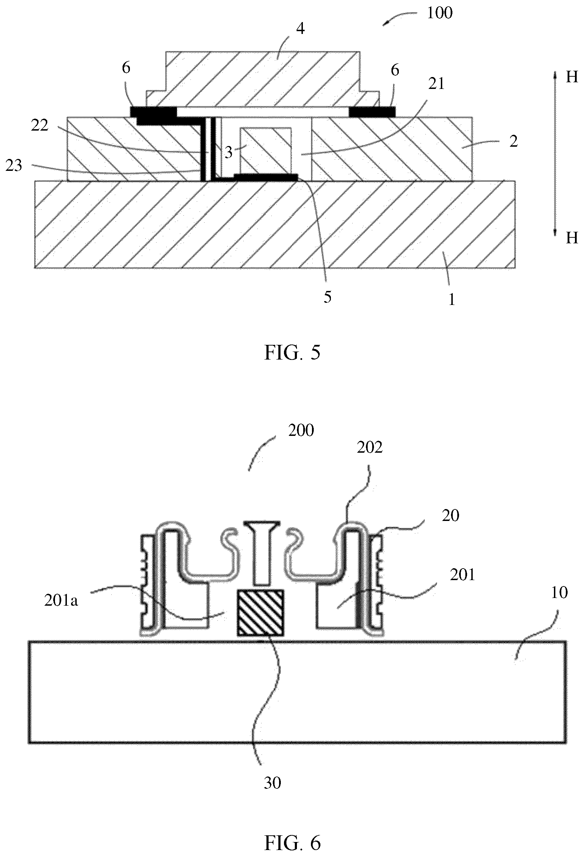

During use, a board-to-board connector of another circuit board assembly is connected to the board-to-board connector 4 in the embodiment shown in FIG. 4, so that the another circuit board assembly can be connected to the circuit board assembly 100 in the embodiment shown in FIG. 4. FIG. 5 is a sectional drawing of a structure of a circuit board assembly according to yet another embodiment which is not covered by the claims. In the embodiment shown in FIG. 5, an accommodation portion 21 of the backing plate 2 of the circuit board assembly 100 is a through via, and is applicable to an electronic device without a shielding requirement. In this embodiment, the circuit board assembly 100 may also include a first soldering pad 5 and/or a second soldering pad 6. A structure and a form of the first soldering pad 5 and the second soldering pad 6 may be the same as those in the embodiment shown in FIG. 4, and details are not described herein again.

The backing plate 2 may also be provided with a first via 22, an inner wall of the first via 22 is provided with a first conductive layer 23, and the first conductive layer 23 may be electrically connected to the first soldering pad 5.

FIG. 6 is a sectional drawing of a structure of a circuit board assembly according to still yet another embodiment which is not covered by the claims. As shown in FIG. 6, the circuit board assembly 200 provided in this embodiment of this application includes a circuit board 10, a board-to-board connector 20, and an electronic element 30. The board-to-board connector 20 is electrically connected to the circuit board 10. The board-to-board connector 20 includes a body 201 and a conductive portion 202. An accommodation portion 201a is provided inside the body 201, the conductive portion 202 is embedded in the body 201, the electronic element 30 is connected to the circuit board 10, and the electronic element 30 is accommodated in the accommodation portion 201a.

The board-to-board connector 20 is electrically connected to the circuit board 10 by using the conductive portion 202, or may be electrically connected to a board-to-board connector in another circuit board assembly by using the conductive portion 202. In this embodiment, the body 201 is a plastic body, the conductive portion 202 is a metal spring, and the metal spring is embedded in the plastic body.

In this embodiment, a height of the body 201 may be increased, so that the body has space for disposing the accommodation portion 201a. The accommodation portion 201a may be a groove or a through groove provided on the body 201. In the embodiment shown in FIG. 6, the accommodation portion 201a is an internal through groove provided at a central position of the body 201, and the electronic element 30 is accommodated in the accommodation portion 201a and connected to the circuit board 10

It may be understood that the embodiment shown in FIG. 6 is merely an example, and the electronic element 30 and the circuit board 10 may also be connected by providing a structure such as a soldering pad or a conductive layer. A shield layer may also be provided according to a design requirement of a circuit board.

An embodiment of this application further provides an electronic device, including more than two circuit board assemblies. Each of the more than two circuit board assemblies includes a board-to-board connector, and the more than two circuit board assemblies are connected by using respective board-to-board connectors. At least one circuit board assembly is the circuit board assembly provided in any embodiment of this application.

In a specific implementation, the electronic device may be a mobile phone. A circuit board assembly includes a mainboard and a board-to-board connector that cooperates with the mainboard, and another circuit board assembly includes a drive circuit board of a camera and a board-to-board connector that cooperates with the drive circuit board. The two board-to-board connectors cooperate with each other to implement connection between the mainboard and the drive circuit board of the camera. In the two circuit board assemblies, at least one circuit board assembly is the circuit board assembly provided in the embodiments of this application, so that the at least one circuit board assembly saves space occupied by an electronic element, thereby facilitating miniaturization and thinning of the mobile phone.

## Claims

1. A circuit board assembly, comprising:
a circuit board (1);
a backing plate (2) fixedly connected to one side of the circuit board (1), wherein the backing plate (2) is provided with an accommodation portion (21);
an electronic element (3) accommodated in the accommodation portion (21) and connected to the circuit board (1);
a board-to-board connector (4) fixedly connected to one side that is of the backing plate (2) and that is away from the circuit board (1); and
the accommodation portion (21) is a blind via provided on the backing plate (2), and the blind via is recessed from one side that is of the backing plate (2) and that is close to the circuit board (1) to one side close to the board-to-board connector (4), wherein an inner wall of the accommodation portion (21) is provided with a shield layer (211).

2. The circuit board assembly according to claim 1, further comprising a first soldering pad (5), wherein the electronic element (3) is fastened and electrically connected to the circuit board (1) by using the first soldering pad (5).

3. The circuit board assembly according to claim 1, further comprising a second soldering pad (6), wherein the board-to-board connector (4) is fixedly connected to the backing plate (2) by using the second soldering pad (6).

4. The circuit board assembly according to claim 3, wherein the backing plate (2) is provided with a first via (22), an inner wall of the first via (22) is provided with a first conductive layer (23), the first conductive layer (23) is electrically connected to the board-to-board connector (4) by using the second soldering pad (6), and the first conductive layer (23) is electrically connected to the circuit board (1).

5. The circuit board assembly according to claim 4, wherein the circuit board (1) is provided with a second via (11), and an inner wall of the second via (11) is provided with a second conductive layer (12); and
the second conductive layer (12) is electrically connected to the electronic element (3).

6. The circuit board assembly according to claim 5, wherein the circuit board (1) is provided with a third via (13), and the third via (13) communicates with the first via (22);
an inner wall of the third via (13) is provided with a third conductive layer (14), and the third conductive layer (14) is electrically connected to the first conductive layer (23); and
the circuit board (1) is further provided with a fourth conductive layer (15), and the fourth conductive layer (15) is electrically connected to the third conductive layer (14) and the second conductive layer (12) separately.

7. An electronic device, comprising more than two circuit board assemblies, wherein each of the more than two circuit board assemblies comprises a board-to-board connector, the more than two circuit board assemblies are connected by using respective board-to-board connectors, and at least one circuit board assembly is the circuit board assembly according to any one of claims 1 to 6.

## Patentansprüche

1. Eine Leiterplattenanordnung, umfassend:
eine Leiterplatte (1);
eine Trägerplatte (2), die fest mit einer Seite der Leiterplatte (1) verbunden ist, wobei die Trägerplatte (2) mit einem Aufnahmeteil (21) versehen ist;
ein elektronisches Bauelement (3), das im Aufnahmeteil (21) untergebracht und mit der Leiterplatte (1) verbunden ist;
einen Board-to-Board-Steckverbinder (4), der fest mit der der Leiterplatte (1) abgewandten Seite der Trägerplatte (2) verbunden ist; und
das Aufnahmeteil (21) ist eine Sackdurchführung, die an der Trägerplatte (2) vorgesehen ist, wobei die Sackdurchführung von der der Leiterplatte (1) zugewandten Seite der Trägerplatte (2) zu der dem Board-to-Board-Steckverbinder (4) zugewandten Seite vertieft ist, wobei eine Innenwand des Aufnahmeteils (21) mit einer Abschirmschicht (211) versehen ist.

2. Die Leiterplattenanordnung nach Anspruch 1, weiterhin umfassend ein erstes Lötpad (5), wobei das elektronische Bauelement (3) mit Hilfe des ersten Lötpads (5) an der Leiterplatte (1) befestigt und elektrisch verbunden ist.

3. Die Leiterplattenanordnung nach Anspruch 1, weiterhin umfassend ein zweites Lötpad (6), wobei der Board-to-Board-Steckverbinder (4) mit Hilfe des zweiten Lötpads (6) fest mit der Trägerplatte (2) verbunden ist.

4. Die Leiterplattenanordnung nach Anspruch 3, wobei die Trägerplatte (2) mit einer ersten Durchkontaktierung (22) versehen ist, eine Innenwand der ersten Durchkontaktierung (22) mit einer ersten leitfähigen Schicht (23) versehen ist, die erste leitfähige Schicht (23) mit Hilfe des zweiten Lötpads (6) elektrisch mit dem Board-to-Board-Steckverbinder (4) verbunden ist und die erste leitfähige Schicht (23) elektrisch mit der Leiterplatte (1) verbunden ist.

5. Die Leiterplattenanordnung nach Anspruch 4, wobei die Leiterplatte (1) mit einer zweiten Durchkontaktierung (11) versehen ist und eine Innenwand der zweiten Durchkontaktierung (11) mit einer zweiten leitfähigen Schicht (12) versehen ist; und
die zweite leitfähige Schicht (12) elektrisch mit dem elektronischen Bauelement (3) verbunden ist.

6. Die Leiterplattenanordnung nach Anspruch 5, wobei die Leiterplatte (1) mit einer dritten Durchkontaktierung (13) versehen ist und die dritte Durchkontaktierung (13) mit der ersten Durchkontaktierung (22) kommuniziert;
eine Innenwand der dritten Durchkontaktierung (13) mit einer dritten leitfähigen Schicht (14) versehen ist und die dritte leitfähige Schicht (14) elektrisch mit der ersten leitfähigen Schicht (23) verbunden ist; und
Die Leiterplatte (1) ist ferner mit einer vierten leitfähigen Schicht (15) versehen, und die vierte leitfähige Schicht (15) ist elektrisch getrennt mit der dritten leitfähigen Schicht (14) und der zweiten leitfähigen Schicht (12) verbunden.

7. Eine elektronische Vorrichtung, umfassend mehr als zwei Leiterplattenanordnungen, wobei jede der mehr als zwei Leiterplattenanordnungen einen Board-to-Board-Steckverbinder umfasst, die mehr als zwei Leiterplattenanordnungen jeweils über entsprechende Board-to-Board-Steckverbinder verbunden sind und mindestens eine Leiterplattenanordnung die Leiterplattenanordnung gemäß einem der Ansprüche 1 bis 6 ist.

## Revendications

1. Un assemblage de carte de circuit imprimé, comprenant :
une carte de circuit imprimé (1) ;
une plaque de support (2) reliée de façon fixe à un côté de la carte de circuit imprimé (1), la plaque de support (2) étant pourvue d'une partie de logement (21) ;
un élément électronique (3) logé dans la partie de logement (21) et connecté à la carte de circuit imprimé (1) ;
un connecteur carte-à-carte (4) relié de façon fixe à un côté de la plaque de support (2), ce côté étant opposé à la carte de circuit imprimé (1) ; et
la partie de logement (21) est un trou borgne pratiqué dans la plaque de support (2), et le trou borgne est formé en creux à partir d'un côté de la plaque de support (2) du côté proche de la carte de circuit imprimé (1) vers le côté proche du connecteur carte-à-carte (4), la paroi intérieure de la partie de logement (21) étant pourvue d'une couche de blindage (211).

2. L'assemblage de carte de circuit imprimé selon la revendication 1, comprenant également une première pastille de soudure (5), l'élément électronique (3) étant fixé et connecté électriquement à la carte de circuit imprimé (1) à l'aide de la première pastille de soudure (5).

3. L'assemblage de carte de circuit imprimé selon la revendication 1, comprenant également une deuxième pastille de soudure (6), le connecteur carte-à-carte (4) étant fixé à la plaque de support (2) à l'aide de la deuxième pastille de soudure (6).

4. L'assemblage de carte de circuit imprimé selon la revendication 3, la plaque de support (2) étant pourvue d'un premier trou (22), la paroi intérieure du premier trou (22) étant pourvue d'une première couche conductrice (23), la première couche conductrice (23) étant connectée électriquement au connecteur carte-à-carte (4) à l'aide de la deuxième pastille de soudure (6), et la première couche conductrice (23) étant connectée électriquement à la carte de circuit imprimé (1).

5. L'assemblage de carte de circuit imprimé selon la revendication 4, la carte de circuit imprimé (1) étant pourvue d'un deuxième trou (11), la paroi intérieure du deuxième trou (11) étant pourvue d'une deuxième couche conductrice (12) ; et
la deuxième couche conductrice (12) étant connectée électriquement à l'élément électronique (3).

6. L'assemblage de carte de circuit imprimé selon la revendication 5, la carte de circuit imprimé (1) étant pourvue d'un troisième trou (13), et le troisième trou (13) communique avec le premier trou (22) ;
la paroi intérieure du troisième trou (13) étant pourvue d'une troisième couche conductrice (14), la troisième couche conductrice (14) étant connectée électriquement à la première couche conductrice (23) ; et
la carte de circuit imprimé (1) est en outre pourvue d'une quatrième couche conductrice (15), et la quatrième couche conductrice (15) est connectée électriquement séparément à la troisième couche conductrice (14) et à la deuxième couche conductrice (12).

7. Dispositif électronique comprenant plus de deux modules de cartes de circuits imprimés, chaque module de carte de circuits imprimés comprenant un connecteur carte à carte, lesdits modules étant connectés par leurs connecteurs carte à carte respectifs, et au moins un module de carte de circuits imprimés étant le module selon l'une quelconque des revendications 1 à 6.
